(19) 

**Europäisches Patentamt**
**European Patent Office**
**Office européen des brevets**

(11) **EP 4 685 505 A1**

(12) **EUROPEAN PATENT APPLICATION**

(43) Date of publication:
**28.01.2026 Bulletin 2026/05**

(21) Application number: **25189786.4**

(22) Date of filing: **16.07.2025**

(51) International Patent Classification (IPC):
**G01R 31/367** (2019.01)  **G01R 31/392** (2019.01)
**G01R 31/374** (2019.01)  **H01M 10/48** (2006.01)

(52) Cooperative Patent Classification (CPC):
**H01M 10/486; G01R 31/367; G01R 31/374;**
**G01R 31/392**

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH LA MA MD TN**

(30) Priority: **26.07.2024 KR 20240099594**

(71) Applicant: **Hyundai Mobis Co., Ltd.**
**Gangnam-gu**
**Seoul 06141 (KR)**

(72) Inventors:
• **LEE, Hoon**
  **16891 Yongin-si (KR)**
• **KIM, Dong Rak**
  **16891 Yongin-si (KR)**
• **LEE, Won Hee**
  **16891 Yongin-si (KR)**
• **LEE, Ji Ho**
  **16891 Yongin-si (KR)**
• **LEE, Hong Jun**
  **16891 Yongin-si (KR)**
• **AN, Hyeon Been**
  **16891 Yongin-si (KR)**
• **GWAN, Da Won**
  **16891 Yongin-si (KR)**
• **JEON, Hye Rim**
  **16891 Yongin-si (KR)**

(74) Representative: **Vossius & Partner**
**Patentanwälte Rechtsanwälte mbB**
**Siebertstrasse 3**
**81675 München (DE)**

(54) **APPARATUS AND METHOD FOR ESTIMATING LIFE OF BATTERY**

(57)     Provided is an apparatus and method for estimating a life of a battery. The method for estimating a life of a battery includes measuring capacities of the battery based on a plurality of different temperatures and a plurality of different currents, selecting a reference capacity of the battery based on a reference temperature and a reference current, applying the reference capacity to each of the measured capacities of the battery to derive compensation values with respect to the plurality of different temperatures and the plurality of different currents, identifying a start extant capacity of the battery at start of use of the battery, integrating the currents of the battery in a use time of the battery, and correcting the integration current to at least one of the compensation values, identifying an end extant capacity of the battery at end of use of the battery, and obtaining the life of the battery based on the start extant capacity of the battery, the end extant capacity of the battery, and the corrected integration current.

FIG. 2

```
Measure battery capacity at specific current and     ⎯ S2100
specific temperature

         ↓

Measure battery capacity under conditions of         ⎯ S2200
different currents and different temperatures

         ↓

Select reference capacity at reference               ⎯ S2300
temperature and reference current

         ↓

Select compensation value Cij with respect to        ⎯ S2400
temperature and current

         ↓

Identify SOCstart corresponding to                   ⎯ S2500
SOC at start of use of battery

         ↓

Integrate current by applying                        ⎯ S2600
compensation value Cij during battery use time

         ↓

Identify SOCend corresponding to SOC at end of use of battery   ⎯ S2700

         ↓

Calculate remaining capacity Q and battery life SOH  ⎯ S2800
```

## Description

## BACKGROUND

### Technical Field

The present disclosure relates to a battery, and more particularly, to an apparatus and method for estimating a life of a battery according to temperature and current.

### Discussion of the Related Art

Generally, batteries generate electricity based on chemical reactions occurring therein, and are provided in most devices equipped with electric devices such as vehicles, etc. Such a battery has a life decreasing as it is used, and methods for estimating the remaining useful life of the battery have been used.

As one of the methods for estimating the remaining useful life of the battery, remaining useful life data of the battery is secured based on a test result to check a capacity retention rate over time based on specific temperature and specific state of charge (SOC) as well as the remaining capacity of the battery is checked based on a charging/discharging cycle test with respect to temperature of the battery and a magnitude of current. Thereafter, the remaining useful life may be estimated with respect to the number of charging/discharging cycles or use time based on the remaining useful life data. As another method for estimating the remaining useful life of the battery, the remaining capacity of the battery may be estimated based on integration of current used during a battery use time and a used SOC period.

However, in case that the life of the battery is estimated based on charging/discharging cycle data and capacity retention rate as described above, in case of actual use of the battery, charging/discharging use history and period used for various current act together, making implementation difficult and complex. In case that the remaining capacity is estimated through integration of current in a use period and an SOC period, current and temperature may be various with respect to a use pattern of the battery, making it difficult to identify an accurate capacity.

## SUMMARY

The present disclosure aims to provide an apparatus and method for more accurately estimating a life of a battery through standard capacity conversion based on a reference temperature and a reference current in case of estimation of a remaining useful life based on current integration in a battery use period and an SOC period.

However, the present disclosure is not limited to the technical problems described above, and the scope of the embodiments may be expanded to other technical problems that may be construed by those of ordinary skill in the art based on the entire contents of the present document.

To achieve these objects and other advantages and in accordance with the purpose of the disclosure, a method for estimating a life of a battery includes measuring capacities of the battery based on a plurality of different temperatures and a plurality of different currents, selecting a reference capacity of the battery based on a reference temperature and a reference current, applying the reference capacity to each of the measured capacities of the battery to derive compensation values with respect to the plurality of different temperatures and the plurality of different currents, identifying a start extant capacity of the battery at start of use of the battery, integrating the currents of the battery in a use time of the battery, and correcting the integration current to at least one of the compensation values, identifying an end extant capacity of the battery at end of use of the battery, and obtaining the life of the battery based on the start extant capacity of the battery, the end extant capacity of the battery, and the corrected integration current.

According to embodiments, selecting the reference capacity may include selecting one of the measured capacities as the reference capacity.

According to embodiments, selecting the reference capacity may include selecting, as the reference capacity, a discharging capacity of 1 C-rate (C) at a specific temperature.

According to embodiments, deriving the compensation value may include dividing each of the measured capacities by the reference capacity to derive compensation values with respect to the plurality of different temperatures and the plurality of different currents.

According to embodiments, deriving the compensation value may include interpolating at least two of the compensation values with respect to the plurality of different temperatures and the plurality of different currents to derive a compensation value with respect to a temperature between the plurality of different temperatures and/or a current between the plurality of different currents.

According to embodiments, correcting the integration current may include multiplying a current of the battery by the compensation value and adding an integration current at a previous time to a result of the multiplying to integrate the current of the battery.

According to embodiments, obtaining the life of the battery may include obtaining a remaining capacity of the battery by subtracting an end extant capacity of the battery from a start extant capacity of the battery and dividing a result of the subtracting by the corrected integration current.

According to embodiments, the obtaining of the life of the battery may include obtaining the life of the battery by dividing a remaining capacity of the battery by a nominal remaining capacity.

According to embodiments, the nominal remaining capacity may be an initial remaining capacity of the battery.

According to embodiments, an apparatus for estimating a life of a battery includes a capacity measurement unit configured to measure capacities of the battery based on a plurality of different temperatures and a plurality of different currents, a reference capacity selection unit configured to select a reference capacity of the battery based on a reference temperature and a reference current, a compensation value deriving unit configured to apply the reference capacity to each of the measured capacities of the battery to derive compensation values with respect to the plurality of different temperatures and the plurality of different currents, a current integration unit configured to identify a start extant capacity of the battery at start of use of the battery, integrate the currents of the battery in a use time of the battery, correct the integration current to at least one of the compensation values, and identify an end extant capacity of the battery at end of the use of the battery, and a battery life calculation unit configured to obtain the life of the battery based on the start extant capacity of the battery, the end extant capacity of the battery, and the corrected integration current.

According to embodiments, the reference capacity selection unit may be configured to select one of the measured capacities as the reference capacity.

According to embodiments, the reference capacity selection unit may be configured to select, as the reference capacity, a discharging capacity of 1 C-rate (C) at a specific temperature.

According to embodiments, the compensation value deriving unit may be configured to divide each of the measured capacities by the reference capacity to derive compensation values with respect to the plurality of different temperatures and the plurality of different currents.

According to embodiments, the compensation value deriving unit may be configured to interpolate at least two of the compensation values with respect to the plurality of different temperatures and the plurality of different currents to derive a compensation value with respect to a temperature between the plurality of different temperatures and/or a current between the plurality of different currents.

According to embodiments, the current integration unit may be configured to multiply a current of the battery by the compensation value and add an integration current at a previous time to a result of the multiplying to integrate the current of the battery.

According to embodiments, the battery life calculation unit may be configured to obtain a remaining capacity of the battery by subtracting the end extant capacity of the battery from the start extant capacity of the battery and dividing a result of the subtracting by the corrected integration current.

According to embodiments, the battery life calculation unit may be configured to obtain the life of the battery by dividing a remaining capacity of the battery by a nominal remaining capacity.

According to embodiments, the nominal remaining capacity may be an initial remaining capacity of the battery.

According to embodiments, a computer program stored on a computer-readable recording medium may be combined with a computer, which is hardware, to perform the method.

The above-described solutions are merely some of various embodiments of the present specification, and those of ordinary skill in the art to which the present specification pertains may infer modified embodiments reflecting the technical features of the present specification through the overall intent described in the present specification.

## BRIEF DESCRIPTION OF THE DRAWINGS

The accompanying drawings, which are included to provide a further understanding of the disclosure and are incorporated in and constitute a part of this application, illustrate embodiment(s) of the disclosure and together with the description serve to explain the principle of the disclosure. In the drawings:

FIG. 1 is a graph showing a relationship among charging/discharging, temperature, and current of a battery, according to embodiments;

FIG. 2 is a flowchart showing an example of a method for estimating a life of a battery, according to embodiments;

FIG. 3 shows an example of battery capacities measured with respect to various temperatures and various currents, according to embodiments;

FIG. 4 shows an example of a compensation value with respect to temperature and current, according to embodiments; and

FIG. 5 is a block diagram showing an example of an apparatus for estimating a life of a battery, according to embodiments.

## DETAILED DESCRIPTION

Hereinafter, embodiments disclosed herein will be described in detail with reference to the accompanying drawings, and the same or similar components are given the same reference numerals, and redundant description thereof will be omitted. The following embodiment is to specify the present disclosure, but is not intended to limit the scope of rights of the present disclosure. It is interpreted that what those of ordinary skill in the art can easily infer from the detailed description and embodiments of the present disclosure falls within the scope of the rights of the present document.

The detailed description of the present document should not be construed in any way as restrictive and should be considered illustrative only. The scope of the present document should be determined by a reasonable interpretation of the appended claims, and all changes within the equivalent scope of the present document are included within the scope of the present document.

Meanwhile, blocks in the attached block diagrams or operations in the attached flowcharts may be implemented directly in hardware, implemented as software modules executed by hardware, or implemented by a combination thereof. In addition, the blocks in the attached block diagrams or the operations in the attached flowcharts may be interpreted as computer program instructions that are loaded into a processor or memory of data processible equipment, such as a general-purpose computer, a special-purpose computer, a portable laptop computer, a network computer, etc., and perform designated functions. As these computer program instructions may be stored in a memory provided in a computer device or a computer-readable memory, the functions described in the blocks of the block diagrams or the operations of the flowcharts may also be produced by an article that includes instruction means for executing the same. In addition, each block or operation may indicate a part of a module, segment or code including one or more executable instructions for executing specific logical function(s). In some alternative embodiments, the functions mentioned in the blocks or operations may be executed out of the specified order. For example, two blocks or operations shown in succession may be performed substantially simultaneously, may be performed in reverse order, or may be performed with some blocks or operations omitted.

Typically, batteries used in vehicles undergo a lot of charging/discharging at different temperatures and different currents, that is, at different temperatures and different currents.

To check a capacity of a battery, reference conditions such as charging current, discharging current, temperature, full charge, and full discharge may be set, and full charge and full discharge may be performed to check a charging capacity during charge or a discharging capacity during discharge, and the charging capacity or discharging capacity or a capacity that combines the charging capacity with the discharging capacity may be measured under the corresponding current conditions in a corresponding temperature test.

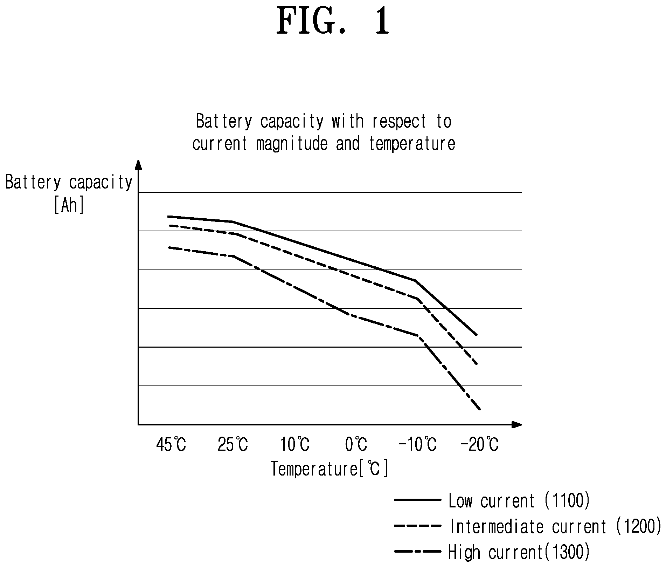

FIG. 1 is a graph showing a relationship among charging/discharging, temperature, and current of a battery, according to embodiments.

In FIG. 1, the graph indicates a change of a capacity (Ah) of a battery with respect to a temperature (°C) and a current magnitude. For example, in the graph of FIG. 1, an X axis indicates a temperature range from -20 °C to 45 °C and a Y axis indicates the capacity of the battery in the unit of Ah. Other three different current magnitudes are shown. Among them, 1100 indicates a low current, 1200 indicates an intermediate current, and 1300 indicates a high current. That is, the battery may be charged/discharged with the low current 1100, with the intermediate current 1200, and with the high current 1300, at a specific temperature.

Referring to FIG. 1, for a change in the capacity of the battery with respect to a current magnitude and a temperature change, at the low current 1100, as the temperature decreases, the capacity of the battery decreases more gently than at other current magnitudes. For example, from 45 °C to 25 °C, the capacity of the battery does not change greatly, and thereafter, decreases slowly. On the other hand, at the intermediate current 1200, the capacity of the battery rapidly decreases from 25 °C. As the temperature approaches -20°C, the capacity sharply decreases. Meanwhile, at the high current 1300, as the temperature decreases, the capacity of the battery decreases most quickly. In particular, at 0 °C or less, the capacity of the battery decreases sharply.

As such, by setting specific conditions, the capacity of the battery may be identified through full charge and/or full discharge.

For example, in case that 1 C-rate (C) charge and 1 C discharge are performed at 25 °C, the capacity of the battery may be measured based on a discharging capacity. Herein, 1 C charge may indicate charging the battery fully for 1 hour and a current charged in this case may be equal to a rated capacity (Ah) of the battery. 1 C discharge may indicate discharging the battery fully for 1 hour and a current discharged in this case may be equal to the rated capacity (Ah) of the battery.

In this way, the capacity of the battery with respect to various temperatures and various current magnitudes may be measured, and capabilities of the battery may be predicted from a tendency shown in FIG. 1.

That is, as the temperature and the current continuously change in a period during which the battery is used actually, the present disclosure intends to accurately estimate the life of the battery even when various temperatures and various currents are used.

The present disclosure derives current compensation information through reference capacity conversion set based on a reference temperature and a reference current, and then correct an integration current by adding the derived current compensation information to the integration current, enabling accurate battery life estimation even in use of the battery at various temperatures and currents.

In the present disclosure, an extant capacity may refer to a state of charge (SOC). The extant capacity may indicate whether the battery is charged 100 % or 50 % in the current charging state. That is, the extant capacity may indicate the current charging state.

A remaining capacity Q may be defined as a capacity available when the battery is charged fully. That is, the remaining capacity may differ with a battery use time. For example, a capacity of a new battery may be greatest when the battery is fully charged, and a capacity of an old battery may be relatively small when the battery is fully charged.

To sum up, the extant capacity indicates the current charging state and thus may be 100 % when the battery is fully charged, whereas the remaining capacity may decrease as the battery is used.

The life of the battery (a state of health (SOH)) may be calculated by using a remaining capacity Q. That is, the life of the battery may be related to a remaining capacity.

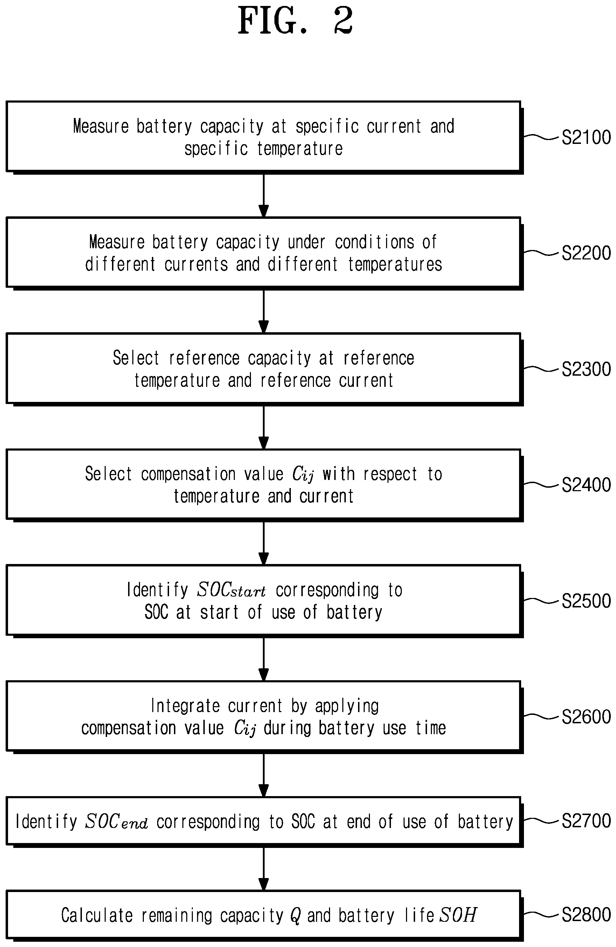

FIG. 2 is a flowchart showing an example of a method for estimating a life of a battery, according to embodiments.

That is, the capacity of the battery at a specific temperature and a specific current may be measured, in operation S2100. Such a measurement process may be performed under conditions of one or more different temperatures and currents to measure the capacity of the battery at a plurality of different temperatures and a plurality of different currents, in operation S2200.

A reference capacity may be selected at a reference temperature and a reference current, in operation S2300.

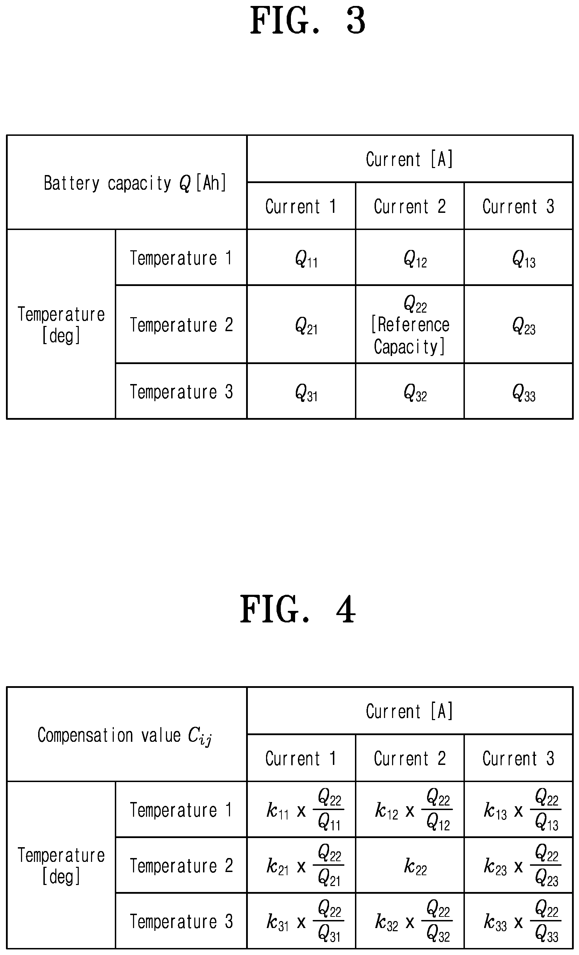

FIG. 3 shows an example of battery capacities measured with respect to various temperatures and various currents, according to embodiments. That is, FIG. 3 shows an example of battery capacities measured through operations S2100 to S2300.

In an embodiment the present disclosure, the discharging capacity of the battery at various temperatures and various currents may be measured based on the graph of FIG. 1.

For example, $Q_{11}$ indicates a discharging capacity measured at temperature 1 and current 1, $Q_{22}$ indicates a discharging capacity measured at temperature 2 and current 2, and $Q_{23}$ indicates a discharging capacity measured at temperature 2 and current 3.

The present disclosure may define, as a reference capacity, the discharging capacity of the battery, measured at a reference temperature and a reference current. This is merely an embodiment, and a charging capacity of the battery, measured at the reference temperature and the reference current, may be set as the reference capacity.

For example, the discharging capacity of 1 C at 25 °C may be set to the reference capacity. In another example, the discharging capacity Q22 of the battery, measured at temperature 2 and current 2, may be set as the reference capacity. In this case, the reference temperature may be temperature 2 and the reference current may be current 2. That is, the present disclosure may set, to the reference capacity, one of discharging capacities of the battery, measured based on various temperatures and various currents.

When the discharging capacities at various temperatures and various currents and the reference capacity are determined through operations S2100 to S2300, a compensation value $C_{ij}$ to be used in current integration with respect to a temperature and a current based on the reference capacity may be derived (or calculated), in operation S2400. In the present disclosure, the compensation value may be referred to current compensation information or integration current compensation information. The present disclosure may perform integration on a current (e.g., a discharging current or a charging current) flowing in the battery to calculate the capacity of the battery.

According to embodiments, as shown in FIG. 4, the present disclosure may divide each discharging capacity measured in S2100 and S2200 by the reference capacity and multiply the result by a correction coefficient k to derive the compensation value $C_{ij}$ with respect to a specific temperature and a specific current. Herein, $C_{ij}$ may indicate a compensation value at an $i^{th}$ temperature and a $j^{th}$ current, and $k_{ij}$ may indicate a correction coefficient at the $i^{th}$ temperature and the $j^{th}$ current. According to embodiments, k with respect to temperature and current may be determined through empirical basis of a designer or additional analysis. Alternatively, a fixed value (e.g., 1) may be applied to any temperature and current. In the present disclosure, k may be referred to as a weight value.

FIG. 4 shows an example of a compensation value with respect to temperature and current, according to embodiments.

For example, $k_{11} \times (Q_{22}/Q_{11})$ may be a compensation value $C_{11}$ obtained by applying the reference capacity $Q_{22}$ and a correction coefficient $k_{11}$ to a discharging capacity $Q_{11}$ measured at temperature 1 and current 1, $k_{13} \times (Q_{22}/Q_{13})$ may be a compensation value C13 obtained by applying the reference capacity $Q_{22}$ and a correction coefficient $k_{13}$ to a discharging capacity $Q_{13}$ measured at temperature 1 and current 3, and $k_{23} \times (Q_{22}/Q_{23})$ may be a compensation value $C_{23}$ obtained by applying the reference capacity $Q_{22}$ and a correction coefficient $k_{23}$ to a discharging capacity Q23 measured at temperature 2 and current 3. The present disclosure may refer to a process of converting this process into the reference capacity. That is, by dividing each discharging capacity measured at various temperatures and various currents by the reference capacity, each discharging capacity measured at various temperatures and various currents may be converted into the reference capacity.

According to embodiments, when the battery operates at a specific temperature and a specific current, a corresponding compensation value may be applied to an integration current. In an embodiment of the present disclosure, the integration current may be corrected by adding the integration current to the compensation value. For example, when the battery actually operates at temperature 1 and current 1, the compensation $C_{11}$ may be used. That is, the compensation value $C_{ij}$ to be applied may differ each time when the temperature and the current at which the battery operates change.

In another embodiment, when the battery operates at a temperature and/or a current not measured in operations S2100 and S2200, that is, a value between the temperatures and/or a value between the currents of FIG. 3, the compensation value may be derived through interpolation. For example, assuming that temperature 1 is 0 °C and temperature 2 is 25 °C, to use a temperature (e.g., 15 °C, 20 °C, etc.) therebetween, a compensation value of 0 °C and a compensation value of 25 °C may be interpolated to derive a compensation value therebetween.

An SOC value at the start of the use of the battery, $SOC_{start}$ (e.g., 0.9) may be identified in operation S2500, and a current flowing through the battery (e.g., a discharging current and/or a charging current) in a use time of the battery may be integrated until the end of use of the battery in operation S2600. In the present disclosure, an SOC may be defined as 1 in full charge and 0 in full discharge. Upon termination of the use of the battery, an SOC at the end of the use of the battery, $SOC_{end}$ may be identified, in operation S2700.

According to embodiments, in operation S2600, during the battery use time, the compensation value $C_{ij}$, a current $I[k]$ actually flowing in the battery, and a discrete operation period $T_s$ may be used to perform current integration Ah_C as in Equation 1. The compensation value $C_{ij}$ may change with temperature and current used.

[Equation 1]

$$Ah\_C[k] = Ah\_C[k-1] + C_{ij} \times \frac{I[k]}{3600} T_s$$

That is, an integration current $Ah\_C[k]$ at the current time may be obtained by multiplying the current $I[k]$ flowing through the battery by the compensation value $C_{ij}$ and adding an integration current $Ah\_C[k-1]$ at a previous time to the result. In this case, before application of the compensation value $C_{ij}$, a process of dividing a constant of 3600 by the current $I[k]$ and multiplying the discrete operation period $T_s$ may be further performed.

In Equation 1, the discrete operation period $T_s$ (or a discrete operation time) may be a predetermined time unit (e.g., 0.1 second). For example, when $T_s$ has a value of 0.1, the present disclosure may derive the compensation value by measuring the temperature and the current in the unit of 0.1 second, and the derived compensation value may be applied to continue integration of the input current $I[k]$. Herein, $Ah\_C[k]$ may indicate the current integration value at the current time, and $Ah\_C[k-1]$ may indicate the current integration value at the previous time. k may be regarded as a digital discrete time, i.e., a compensation value deriving period. For example, assuming that the discrete operation period $T_s$ is 0.1 second, k may be 0 at 0 second, k may be 1 at 0.1 second, and k may be 2 at 0.2 second. In Equation 1, 3600 may be used for unit conversion and to set an hour. That is, 3600 may mean 3600 seconds.

When the use of the battery ends and $SOC_{end}$ is identified in operation S2700, the current integration value Ah_C at that time, the remaining capacity Q may be calculated based on the SOC $SOC_{start}$ at the start of the use of the battery, and the SOC $SOC_{end}$ at the end of the use of the battery as in Equation 2, in operation S2800.

[Equation 2]

$$Q = \frac{Ah\_C}{SOC_{start} - SOC_{end}}$$

That is, as in Equation 2, the remaining capacity Q may be obtained by subtracting the SOC $SOC_{end}$ at the end of the use of the battery from the SOC $SOC_{start}$ at the start of the use of the battery and dividing the result by the current integration value Ah_C.

By doing so, even in case that the battery is continuously used at currents of different magnitudes or different temperatures, remaining capacity conversion at a reference capacity and a reference temperature may be possible, based on which the remaining capacity management and monitoring of the battery may be performed.

In operation S2800, by using the remaining capacity Q, a battery life SOH may be obtained as in Equation 3.

[Equation 3]

$$SOH = \frac{Q}{Q_{nominal}}$$

That is, by dividing $Q_{nominal}$ by the remaining capacity Q as in Equation 3, the battery life SOH may be obtained. Herein, $Q_{nominal}$ may mean an initial capacity of the battery (i.e., a capacity of a new battery), a capacity in a battery shipment stage of a design capacity or beginning of life (BOC) stage, or a capacity of a new battery measured at the reference temperature or the reference current. That is, $Q_{nominal}$ may be defined as an initial remaining capacity of the battery. Herein, the capacity may be a discharging capacity or a charging capacity. Alternatively, the capacity may be an average of charging/discharging capacities.

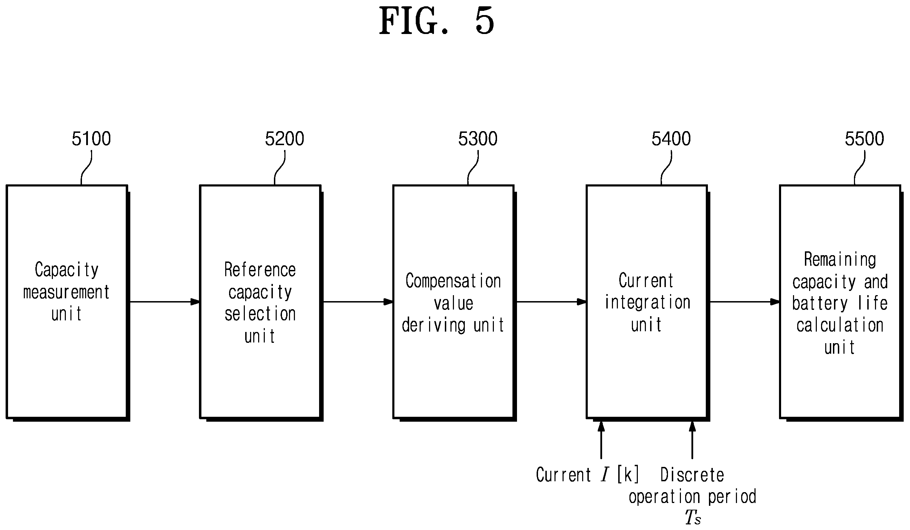

FIG. 5 is a block diagram showing an example of an apparatus for estimating a life of a battery, according to embodiments.

An apparatus for estimating the life of the battery, shown in FIG. 5, may include a capacity measurement unit 5100, a reference capacity selection unit 5200, a compensation value deriving unit 5300, a current integration unit 5400, and a remaining capacity and battery life calculation unit 5500. In FIG. 5, each component of the apparatus for estimating the life of the battery in FIG. 5 may be implemented as hardware, software, and/or a combination thereof. An execution order of each block of the apparatus for estimating the life of the battery may be changed, and some blocks may be omitted and newly added.

The apparatus for estimating the life of the battery, shown in FIG. 5, may be an apparatus for executing the method for estimating the life of the battery, shown in FIG. 2, and a part not described herein will refer to the description of FIGS. 2 to 4.

The capacity measurement unit 5100 may measure the capacity of the battery at various temperatures and various currents. Herein, the capacity of the battery may be a discharging capacity, a charging capacity, or an average of the discharging capacity and the charging capacity. In an embodiment of the present disclosure, the capacity of the battery may be a discharging capacity.

The reference capacity selection unit 5200 may select the reference capacity at the reference temperature and the reference current. The present disclosure may define, as a reference capacity, the discharging capacity of the battery, measured at a reference temperature and a reference current. Alternatively, the present disclosure may set, to the reference capacity, one of discharging capacities of the battery, measured based on various temperatures and various currents.

The compensation value deriving unit 5300 may apply the reference capacity selected by the reference capacity selection unit 5200 to a capacity of each battery, measured by the capacity measurement unit 5100 to derive (or calculate) $C_{ij}$ to be used for current integration. In the present disclosure, the compensation value may be referred to current compensation information or integration current compensation information. According to embodiments, as shown in FIG. 4, the present disclosure may divide each discharging capacity, measured by the capacity measurement unit 5100, by the reference capacity and multiply the result by a correction coefficient k to derive the compensation value $C_{ij}$ with respect to a specific temperature and a specific current. Herein, $C_{ij}$ may indicate a compensation value at an $i^{th}$ temperature and a $j^{th}$ current, and $k_{ij}$ may indicate a correction coefficient at the $i^{th}$ temperature and the $j^{th}$ current. According to embodiments, k with respect to temperature and current may be determined through empirical basis of a designer or additional analysis. Alternatively, a fixed value (e.g., 1) may be applied to any temperature and current. The present disclosure may refer to a process of converting this process into the reference capacity. That is, by dividing each discharging capacity measured at various temperatures and various currents by the reference capacity, each discharging capacity measured at various temperatures and various currents may be converted into the reference capacity.

The current integration unit 5400 may apply the corresponding compensation value derived by the compensation value deriving unit 5300 to the integration current to correct the integration current when the battery operates at a specific temperature and a specific current. In an embodiment of the present disclosure, the integration current may be corrected by adding the integration current to the compensation value. For example, when the battery actually operates at temperature 1 and current 1, the compensation C11 may be used. That is, the compensation value $C_{ij}$ to be applied may differ each time when the temperature and the current at which the battery operates change.

In another embodiment, when the battery operates at a temperature and/or a current not measured by the capacity measurement unit 5100, the compensation value may be derived through interpolation.

The current integration unit 5400 may identify the SOC $SOC_{start}$ at the start of the use of the battery, apply the compensation value with respect to the temperature and the current during the battery use time to integrate the input current, and identify the SOC $SOC_{end}$ at the end of the use of the battery when the use of the battery ends.

According to embodiments, during the battery use time, the battery integration unit 5400 may perform current integration Ah_C by using the compensation value $C_{ij}$, the input current I[k], and the discrete operation period $T_s$ as in

Equation 1.

When the current integration unit 5400 identifies the SOC $SOC_{end}$ after the end of the use of the battery, the remaining capacity and battery life calculation unit 5500 may calculate the remaining capacity Q based on the current integration value Ah_C, the SOC $SOC_{start}$ at the start of the use of the battery, and the SOC $SOC_{end}$ at the end of the use of the battery.

In the present disclosure, the remaining capacity Q may be obtained by subtracting the SOC $SOC_{end}$ at the end of the use of the battery from the SOC $SOC_{start}$ at the start of the use of the battery and dividing the result by the current integration value Ah_C.

The remaining capacity and battery life calculation unit 5500 may calculate the battery life SOH by using the remaining capacity Q.

In the present disclosure, the battery life SOH may be obtained by dividing $Q_{nominal}$ by the remaining capacity Q. Herein, $Q_{nominal}$ may mean an initial capacity of the battery (i.e., a capacity of a new battery), a capacity in a battery shipment stage of a design capacity or beginning of life (BOC) stage, or a capacity of a new battery measured at the reference temperature or the reference current. That is, $Q_{nominal}$ may be defined as an initial remaining capacity of the battery.

The apparatus and method for estimating the life of the battery according to embodiments may accurately estimate the life even in the use of various temperatures and currents through reference capacity conversion based on the reference temperature and current when the extant capacity is estimated through current integration during the battery use time and the SOC period.

The apparatus and method for estimating the life of the battery according to embodiments may manage a battery life cycle such as conversion of waste batteries through battery history management.

The apparatus and method for estimating the life of the battery according to embodiments may improve battery management capability such as an SOC, a state of power (SOP), etc., estimated based on accurate battery life.

In addition to the technical effects explicitly mentioned above, effects that are obvious to those of ordinary skill in the art may also be inferred from the entire description of the present specification.

Each part, module or unit described above may be software, processor or hardware parts that execute sequential execution processes stored in a memory (or storage unit). Each operation described in the foregoing embodiment may be performed by processor, software, and hardware parts. Each module/block/unit described in the above-described embodiment may operate as a processor, software, or hardware. Additionally, the methods presented in the embodiments may be implemented as code. This code may be written to a processor-readable storage medium and may therefore be read by a processor provided by the apparatus.

Although the present specification has been described for each drawing separately for convenience of a description, it is also possible to design a new embodiment by combining the embodiments described in each drawing. In addition, it is also within the scope of the present disclosure to design a computer-readable recording medium having recorded thereon a program for executing the previously described embodiments, as required by those of ordinary skill in the art.

The apparatus and method according to the present disclosure are not limitedly applied to the configuration and method for the embodiments described above, but the embodiments may be configured by selectively combining all or part of the embodiments such that various modifications can be made.

In the present disclosure, terms such as first, second, etc. may be used to describe various components of the present disclosure. However, various components according to the present disclosure should not be limited in interpretation by the foregoing terms. These terms are only used to distinguish one component from another. For example, a first user input signal may be referred to as a second user input signal. Similarly, the second user input signal may be referred to as the first user input signal. Any use of these terms should be construed as not departing from the scope of the various embodiments. Although both the first user input signal and the second user input signal are user input signals, they do not mean the same user input signals unless the context clearly indicates otherwise.

The terminology used to describe the present disclosure is for the purpose of describing particular embodiments only and is not intended to be limiting of the embodiments. As used in the description of the embodiments and in the claims, the singular is intended to include the plural unless the context clearly dictates otherwise. Additionally, the expression "and/or" is used to mean all possible combinations of terms. The expression "include" describes the presence of features, numbers, operations, elements, and/or components, but does not imply the exclusion of additional features, numbers, operations, elements, and/or components. Conditional expressions such as in case that, when, etc., used to describe the present disclosure are not to be interpreted as being limited to only optional cases. When certain conditions are satisfied, it is intended that a related operation be performed in response to certain conditions, or that a related definition be interpreted.

**Claims**

1. A method for estimating a life of a battery, the method comprising:

   measuring capacities of the battery based on a plurality of different temperatures and a plurality of different currents;
   selecting a reference capacity of the battery based on a reference temperature and a reference current;
   applying the reference capacity to each of the measured capacities of the battery to derive compensation values with respect to the plurality of different temperatures and the plurality of different currents;
   identifying a start extant capacity of the battery at start of use of the battery, integrating the currents of the battery in a use time of the battery, and correcting the integration current to at least one of the compensation values;
   identifying an end extant capacity of the battery at end of use of the battery; and
   obtaining the life of the battery based on the start extant capacity of the battery, the end extant capacity of the battery, and the corrected integration current.

2. The method of claim 1, wherein selecting the reference capacity comprises selecting one of the measured capacities as the reference capacity.

3. The method of claim 1, or 2, wherein selecting the reference capacity comprises selecting, as the reference capacity, a discharging capacity of 1 C-rate (C) at a specific temperature.

4. The method of claim 1, 2, or 3, wherein the deriving the compensation value comprises dividing each of the measured capacities by the reference capacity to derive compensation values with respect to the plurality of different temperatures and the plurality of different currents.

5. The method of any one of claims 1 to 4, wherein deriving the compensation value comprises interpolating at least two of the compensation values with respect to the plurality of different temperatures and the plurality of different currents to derive a compensation value with respect to a temperature between the plurality of different temperatures and/or a current between the plurality of different currents.

6. The method of any one of claims 1 to 5, wherein correcting the integration current comprises multiplying a current of the battery by the compensation value and adding an integration current at a previous time to a result of the multiplying to integrate the current of the battery.

7. The method of any one of claims 1 to 6, wherein obtaining the life of the battery comprises obtaining a remaining capacity of the battery by subtracting the end extant capacity of the battery from the start extant capacity of the battery and dividing a result of the subtracting by the corrected integration current.

8. The method of claim 7, wherein obtaining the life of the battery comprises obtaining the life of the battery by dividing a remaining capacity of the battery by a nominal remaining capacity.

9. The method of claim 7, or 8, wherein the nominal remaining capacity is an initial remaining capacity of the battery.

10. An apparatus for estimating a life of a battery, the apparatus comprising:

    a capacity measurement unit configured to measure capacities of the battery based on a plurality of different temperatures and a plurality of different currents;
    a reference capacity selection unit configured to select a reference capacity of the battery based on a reference temperature and a reference current;
    a compensation value deriving unit configured to apply the reference capacity to each of the measured capacities of the battery to derive compensation values with respect to the plurality of different temperatures and the plurality of different currents;
    a current integration unit configured to identify a start extant capacity of the battery at start of use of the battery, integrate the currents of the battery in a use time of the battery, correct the integration current to at least one of the compensation values, and identify an end extant capacity of the battery at end of the use of the battery; and
    a battery life calculation unit configured to obtain the life of the battery based on the start extant capacity of the battery, the end extant capacity of the battery, and the corrected integration current.

11. The apparatus of claim 10, wherein the reference capacity selection unit is configured to select one of the measured capacities as the reference capacity.

12. The apparatus of claim 10, or 11, wherein the reference capacity selection unit is configured to select, as the reference capacity, a discharging capacity of 1 C-rate (C) at a specific temperature.

13. The apparatus of claim 10, 11, or 12, wherein the compensation value deriving unit is configured to divide each of the measured capacities by the reference capacity to derive compensation values with respect to the plurality of different temperatures and the plurality of different currents.

14. The apparatus of any one of claims 10 to 13, wherein the compensation value deriving unit is configured to interpolate at least two of the compensation values with respect to the plurality of different temperatures and the plurality of different currents to derive a compensation value with respect to a temperature between the plurality of different temperatures and/or a current between the plurality of different currents.

15. The apparatus of any one of claims 10 to 14, wherein the current integration unit is configured to multiply a current of the battery by the compensation value and add an integration current at a previous time to a result of the multiplying to integrate the current of the battery.

16. The apparatus of any one of claims 10 to 15, wherein the battery life calculation unit is configured to obtain a remaining capacity of the battery by subtracting the end extant capacity of the battery from the start extant capacity of the battery and dividing a result of the subtracting by the corrected integration current.

17. The apparatus of claim 16, wherein the battery life calculation unit is configured to obtain the life of the battery by dividing a remaining capacity of the battery by a nominal remaining capacity.

18. The apparatus of claim 17, wherein the nominal remaining capacity is an initial remaining capacity of the battery.

19. A computer program having stored thereon a computer-readable recording medium to execute the method of any one of claims 1 to 9 in connection to a computer which is hardware.

# FIG. 1

Battery capacity with respect to
current magnitude and temperature

# FIG. 2

Measure battery capacity at specific current and
specific temperature ~S2100

Measure battery capacity under conditions of
different currents and different temperatures ~S2200

Select reference capacity at reference
temperature and reference current ~S2300

Select compensation value $C_{ij}$ with respect to
temperature and current ~S2400

Identify $SOC_{start}$ corresponding to
SOC at start of use of battery ~S2500

Integrate current by applying
compensation value $C_{ij}$ during battery use time ~S2600

Identify $SOC_{end}$ corresponding to SOC at end of use of battery ~S2700

Calculate remaining capacity $Q$ and battery life $SOH$ ~S2800

# FIG. 3

| Battery capacity $Q$ [Ah] | | Current [A] | | |
|---|---|---|---|---|
| | | Current 1 | Current 2 | Current 3 |
| Temperature [deg] | Temperature 1 | $Q_{11}$ | $Q_{12}$ | $Q_{13}$ |
| | Temperature 2 | $Q_{21}$ | $Q_{22}$ [Reference Capacity] | $Q_{23}$ |
| | Temperature 3 | $Q_{31}$ | $Q_{32}$ | $Q_{33}$ |

# FIG. 4

| Compensation value $C_{ij}$ | | Current [A] | | |
|---|---|---|---|---|
| | | Current 1 | Current 2 | Current 3 |
| Temperature [deg] | Temperature 1 | $k_{11} \times \dfrac{Q_{22}}{Q_{11}}$ | $k_{12} \times \dfrac{Q_{22}}{Q_{12}}$ | $k_{13} \times \dfrac{Q_{22}}{Q_{13}}$ |
| | Temperature 2 | $k_{21} \times \dfrac{Q_{22}}{Q_{21}}$ | $k_{22}$ | $k_{23} \times \dfrac{Q_{22}}{Q_{23}}$ |
| | Temperature 3 | $k_{31} \times \dfrac{Q_{22}}{Q_{31}}$ | $k_{32} \times \dfrac{Q_{22}}{Q_{32}}$ | $k_{33} \times \dfrac{Q_{22}}{Q_{33}}$ |

# FIG. 5

5100 Capacity measurement unit

5200 Reference capacity selection unit

5300 Compensation value deriving unit

5400 Current integration unit

5500 Remaining capacity and battery life calculation unit

Current $I[k]$   Discrete operation period $T_s$

EP 4 685 505 A1

Europäisches
Patentamt

European
Patent Office

Office européen
des brevets

# EUROPEAN SEARCH REPORT

**Application Number**

EP 25 18 9786

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | CN 106 324 508 A (HUAWEI TECH CO LTD; UNIV TSINGHUA) 11 January 2017 (2017-01-11) * the whole document * | 1-19 | INV. G01R31/367 G01R31/392 G01R31/374 |
| Y | CN 110 346 725 A (UBIAI INFORMATION TECH BEIJING CO LTD) 18 October 2019 (2019-10-18) * the whole document * | 1-19 | H01M10/48 |
| A | JP WO20 1408 3856 A1 (-) 5 January 2017 (2017-01-05) * the whole document * | 1-19 | |
| A | KR 100 911 317 B1 (LG CHEMICAL LTD [KR]) 11 August 2009 (2009-08-11) * the whole document * | 1-19 | |

**TECHNICAL FIELDS SEARCHED (IPC)**

G01R

The present search report has been drawn up for all claims

| Place of search | Date of completion of the search | Examiner |
|---|---|---|
| Munich | 13 November 2025 | Moulara, Guilhem |

EPO FORM 1503 03.82 (P04C01)

## ANNEX TO THE EUROPEAN SEARCH REPORT
## ON EUROPEAN PATENT APPLICATION NO.

EP 25 18 9786

This annex lists the patent family members relating to the patent documents cited in the above-mentioned European search report.
The members are as contained in the European Patent Office EDP file on
The European Patent Office is in no way liable for these particulars which are merely given for the purpose of information.

13-11-2025

| Patent document cited in search report | | Publication date | Patent family member(s) | | Publication date |
|---|---|---|---|---|---|
| CN 106324508 | A | 11-01-2017 | CN | 106324508 A | 11-01-2017 |
| | | | EP | 3285081 A2 | 21-02-2018 |
| | | | US | 2018088181 A1 | 29-03-2018 |
| | | | WO | 2017000912 A2 | 05-01-2017 |
| CN 110346725 | A | 18-10-2019 | NONE | | |
| JP WO2014083856 | A1 | 05-01-2017 | JP | WO2014083856 A1 | 05-01-2017 |
| | | | US | 2015293183 A1 | 15-10-2015 |
| | | | WO | 2014083856 A1 | 05-06-2014 |
| KR 100911317 | B1 | 11-08-2009 | NONE | | |

EPO FORM P0459

For more details about this annex : see Official Journal of the European Patent Office, No. 12/82